Europäisches Patentamt

European Patent Office

Office européen des brevets

(11) Publication number: **0 174 038**
**A2**

(12) **EUROPEAN PATENT APPLICATION**

(21) Application number: **85201091.7**

(22) Date of filing: **05.07.85**

(51) Int. Cl.⁴: **H 01 L 29/86**
**H 01 L 27/08, H 01 C 17/22**

(30) Priority: **05.09.84 IT 2252184**

(43) Date of publication of application:
**12.03.86 Bulletin 86/11**

(84) Designated Contracting States:
**DE FR GB NL**

(71) Applicant: **SGS-ATES Componenti Elettronici S.p.A.**
**Strada Primosole, 50**
**I-95121 Catania(IT)**

(72) Inventor: **Picco, Paolo**
**via Carlo Alberto, 39**
**I-20052 Monza (Milano)(IT)**

(74) Representative: **Mittler, Enrico**
**c/o Marchi & Mittler s.r.l. Viale Lombardia, 20**
**I-20131 Milano(IT)**

(54) **Resistive voltage divider for integrated circuits.**

(57) The voltage divider is formed of monocrystalline silicon resistive components (2,3) obtained by dope implantation and subsequent diffusion.

Fig.1

EP 0 174 038 A2

"Resistive Voltage Divider for Integrated Circuits"

\* \* \* \* \*

The present invention relates to a resistive voltage divider for integrated circuits.

In designing integrated circuits some applications require the use of voltage dividers.

The types of dividers which may be accomplished are numerous. In integrated circuit technology capacitive dividers, MOS dividers or resistive dividers are employed.

Capacitive dividers are made up of a series of condensers. They are very extensive in surface area and cannot be employed in applications which require a high current load.

MOS dividers are formed of series of MOS transistors. They are therefore more compact than capacitive dividers and are suitable for strong current loads but their precision is conditioned by the many variables which characterize MOS transistors such as for example threshold variations and dimensional variations. Their precision is less than that of capacitive dividers.

Resistive dividers produced at present are made of polycrystalline silicon. Their total resistance must be high to limit dissipation. If they are not made of polycrystalline silicon with low specific resistivity they are precise but very extended in surface area. If they are made of nearly intrinsic polycrystalline silicon they are very compact but technologically difficult to control. In other words, their characteristics are difficult to reproduce.

The object of the present invention is to accomplish a resistive voltage divider which is advantageous compared with resistive dividers in use at present and compared with the other types of dividers described above.

According to the invention a resistive voltage divider character-

An intrinsic difficulty with this resistive voltage divider may be the behaviour or the resistive components in relation to the various possible polarizations. Said resistive components do not have a current/voltage linear characteristic and the deviations from linearity are dependent on the manufacturing process of the component and on its geometric characteristics.

This effect must be allowed for to obtain correct sizing of the resistors making up the divider, i.e. to correctly determine their length.

The present invention provides a method of calculation to solve this problem and obtain a degree of precision not achievable with the types of divider at present employed.

It is important to describe the problem and the procedure briefly.

The nonlinearity of the current/voltage characteristic of the resistors diffused in the monocrystalline silicon is due to progressive depletion of electric charge carriers induced in the resistors by the increase in the reverse voltage with respect to the substrate.

Consequently the notion of stratum "resistivity" normally expressed as "frame resistance" should now be expressed as "frame resistance at a given applied voltage". In the presence of depletion effects it is important to specify the width of the resistor under consideration. On narrow resistors side depletion has greater weight than on wide resistors.

It is therefore necessary to express stratum resistivity as "resistance per frame at a given voltage for a given resistor width".

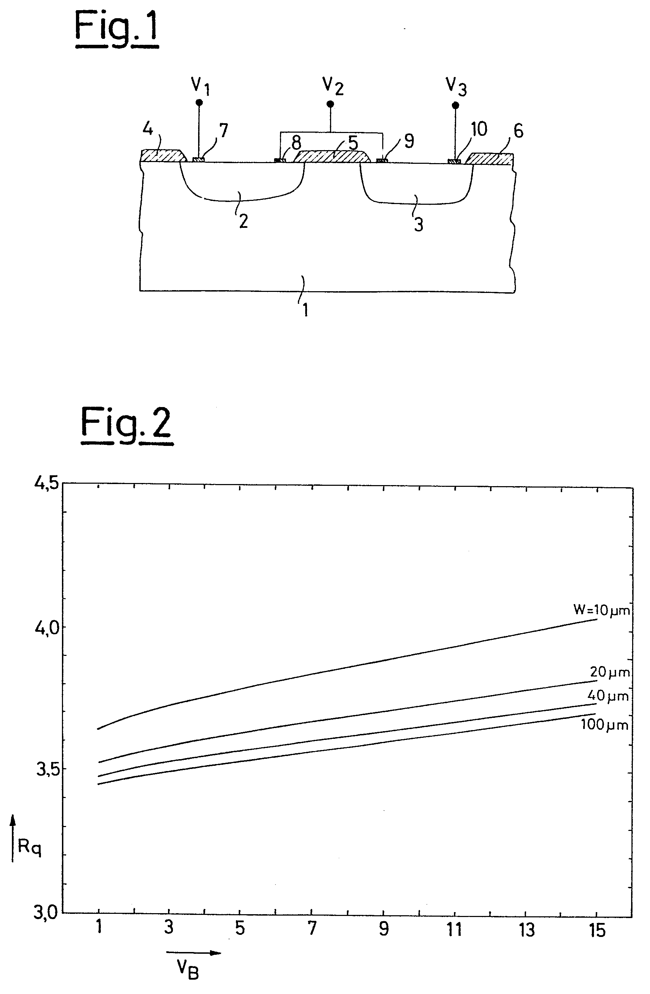

This effect is clearly illustrated in Fig. 2 wherein stratum resistivity $R_q$ is shown on the ordinate and is an increasing ized in that it is made up of monocrystalline silicon resistive components obtained by the implantation of a dope and its subsequent diffusion has been accomplished.

It has been possible to ascertain that the divider according to the invention actually combines numerous advantages only present separately in the various types of voltage dividers without suffering their drawbacks.

It can withstand high current loads. It can have high total resistive value in a very restricted area capable of limiting dissipation. It can be produced with amply proven techniques now present in every integrated circuit production process. Its characteristics are therefore precise and readily reproduced.

For greater clarity the annexed drawings illustrate a voltage divider accomplished according to the present invention.

Fig. 1 shows a schematic longitudinal cross sectional view of one.

Fig. 2 shows a chart which can be used for calculating the dimensions of said resistive divider when particularly high precision is desired.

Fig. 1 shows a substrate of monocrystalline silicon 1 on which are implanted and diffused resistive components 2 and 3 which constitute doped areas of a type opposite to that of the substrate. Areas of oxide 4, 5, and 6 electrically insulate the two resistive components 2 and 3 which have electrical contacts 7, 8 and 9, 10. The electrical contacts 7 and 10 form the end terminals (voltages $V_1$ and $V_2$) of the voltage divider while the electrical contacts 8 and 9 which are interconnected form the intermediate terminal (voltage $V_2$) of said voltage divider, i.e. the output of the divider. The diagram is applicable to dividers with several intermediate outputs.

function of the voltage $V_B$ applied to the resistor which is shown on the abscissa.

Let us examine for example the case of a divider with a single output such as the one shown in Fig. 1. It is desired to obtain a voltage $V_2 = (V_1 + V_3)/2$, i.e. exactly intermediate between the end voltages. If the resistors behaved linearly their length would be equal. But in this case it is necessary to design the second resistor of length $L_2 < L_1$. The section of the divider between $V_1$ and $V_2$ has a stratum resistivity less than that between $V_2$ and $V_3$ because in said section the reverse polarization voltage with respect to the substrate is less than in the following section, the applied voltage and hence the depletion effect being less.

The curves shown in Fig. 2 are based on a single measurement of the current which passes through two specimen resistors one of which is substantially wide and the other substantially narrow of width $W_0$.

With the aforesaid measurements are obtained the values $\gamma (V_B)$ and $\beta (V_B)$ which represent the lateral and vertical contributions to the resistive variation brought about by "depletion" of the doped area induced along the resistive component by the increase of $V_B$ which is the reversed polarization voltage with respect to the substrate.

The values of  and  being calculated, it is possible to use the relationship

$$f(V_B, W) = \gamma (V_B) + (W_0/W) ( \beta (V_B) - \gamma (V_B))$$

wherein W is the width of the resistor which must really be employed.

$f(V_B, W)$ being found, its value may be inserted in the relation

$$Q (V) = Q_0 (1-f(V, W)$$

wherein $Q (V)$ is the density of the charge carriers per unit of area

and $Q_0$ is the effective implanted dope.    Substituting Q (V) in

$$dV = I \, dx/W\mu \, Q(x)$$

wherein $\mu$ is effective mobility and then integrating, it is possibile to find the value of the frame resistance as a function of the voltage applied to its ends and plot the various curves of Fig. 2.

In other words, an appropriate algorithm is used to develop a measurement performed once on two specimen resistors.

Lastly, the range of application of the invention described herein is given.

Strictly speaking, there are no limits to the range of stratum resistivity values with which the voltage dividers described herein may be manufactured.

In practice, the present invention has a highly innovative character in the range from 1 to 10 ohm/frame.

The lower limit, 1 kohm/frame, is the upper limit of the range of resistivity obtainable by using polycrystalline silicon resistors. Implanted resistors with stratum resistivity lower than 1 kohm/-frame do not offer great advantages compared with those accomplished with polycrystalline silicon.

The upper limit, 10 kohm/frame, is imposed by the mobile charge depletion effect described above, which becomes difficult to control above said value.

CLAIMS

1. Resistive voltage divider for integrated circuits characterized in that it is made up of monocrystalline silicon components obtained by implantation and subsequent diffusion of a dope.

2. Method of accomplishment of a resistive voltage divider according to claim 1 characterized in that it comprises the implantation and diffusion of doped areas costituting resistive components of monocrystalline silicon.

3. Method for the calculation and sizing of the resistive components of a voltage divider according to claim 1 characterized in that it includes the preliminary accomplishment of a chart showing the variations in resistance of the unitary area (frame) of the component with the polarization voltage for the various possible widths of the resistive component, the use of said chart for determining the unitary area resistance necessary for a component of the selected width to obtain the desired ouput voltage, and the calculation of the number of unitary areas necessary to obtain a resistive component of the desired value with the selected width and the given polarization voltage.

4. Method according to claim 3 characterized in that said chart is calculated by measuring the current which passes through two specimen resistances and the subsequent employment of the following relations

$$f(V_B, W) = \gamma (V_B) + (W_0/W) ( \beta (V_B) - \gamma (V_B))$$

wherein $\gamma (V_B)$ and $\beta (V_B)$ are the depletions of the central area and of the lateral areas of the resistive component, $W$ is the width of the resistive component, and $W_0$ is the width of a "narrow" resistor selected as a function of the manufacturing process

$$Q (V) = Q_0 (1-f(V, W)$$

wherein $Q_0$ is the effective implanted dose, and

0174038

$$dV = I \ dx/W\mu \ Q(x)$$

and integration of the last relation.

# Fig.1

$V_1$   $V_2$   $V_3$

4   7   8   5   9   10   6

2   3

1

# Fig.2